# EUROPEAN PATENT APPLICATION

(11) **EP 1 328 021 A1**
(43) Date of publication of application: **16.07.2003**
(21) Application number: 02000606.0
(22) Date of filing: 10.01.2002
(51) Int. Cl.: H01L 23/40

(54) **Heat sink device retainer**

(71) Applicant: Wei, Wen-Chen, Taipei Hsien (TW)
(72) Inventor: Wei, Wen-Chen, Taipei Hsien (TW)
(74) Representative: Zeitler, Giselher (DE)

(57) **Abstract**

A heat sink device structure includes one press member and a retaining member; the said press member bends downwardly to form a press portion with resilience; one end thereof bends downwardly to form a retaining hole; two sides of the bottom portion at the other end extend to form a pair of opposite fastening panels; an insert hole is disposed on the said fastening panel and the tail end thereof outwardly forms an opening; a wrench portion is disposed at the upper end of the said retaining member; the wrench portion bends downwardly to form an upper body; the lower end of the upper body extends as a support for connecting a lower retaining body; a retaining hole is disposed on the lower retaining body; two convex blocks are disposed on two sides of the said support and inserted correspondingly into the insert holes for positioning.

## Description

### BACKGROUND OF THE INVENTION

### 1) FIELD OF THE INVENTION

The present invention relates to a heat sink device retainer, more specifically, a retaining assembly for the computer CPU and the heat sink device to provide a retaining structure easy and convenient for assembling and disassembling.

### 2) DESCRIPTION OF THE PRIOR ART

Accordingly, for facilitating the heat dissipation, usually a heat sink device is assembled to the CPU of a personal computer for maintaining the stability of the computer operation. Due to the continuous development of the integrated circuits with high power rate and the reduced volumes of the chips, most of the CPU manufacturers pivotally mount hook feet on the CPU transferring member to correspondingly retain a heat sink device and facilitate the assembly and disassembly. There are many kinds of retainer structures available on the market for assembling the computer CPU and the heat sink device with obvious efficiencies, however, they all have varioust shortcomings as follows:
1. being a complicated structure and assembly;
2. being a fixed structure without flexibility;
3. with too many elements and time-consuming manufacture;
4. with too many parts and increased costs;
5. being tool-depended and inconvenient for operation.

In view of the various shortcomings of the conventional structures, the inventor of the present invention, based on the experience gained from actual engagement and after continuous researches, finally culminated in the present invention.

### SUMMARY OF THE INVENTION

Specifically, the present invention is disposed with a press member and a retainer member, wherein the said press member is a long panel body with a press portion formed by bending a proper portion thereof downwards to make the two sides incline and fold upwards with resilience; the said press portion is disposed more closely to one end for facilitating the press and the force exertion on the other end; two sides have pressed concave portions for reinforcement; the end closer to the press potion bends downwardly with a retaining hole for retaining a hook foot of the CPU transfer member; two sides on the bottom portion at other end thereof extend to have a pair of fastening panels; an insert hole is disposed on each fastening panel; the tail end of the fastening panel outwardly forms an opening; the said retaining member is designed to assemble with the press member; the upper end of the retaining member is disposed with a wrench portion with an inclined surface to facilitate an easy force exertion during the assembling; the said wrench portion bends downwardly to form an upper retainer body; the lower end of the upper retainer body extends as a support for connecting the lower retainer body; on the said lower retainer body, an insert hole is disposed to be fixedly hooked to the hook foot of the transfer member of the CPU; two convex blocks are disposed on the two sides of the support; the retaining member inserts easily into the expanded opening at the tail end of the fastening panel to make the two convex blocks just correspondingly insert into the insert holes and further conjoin the press member and the retaining member correspondingly; since the convex blocks rotates freely in the insert holes, the retaining member can be lively adjusted; during rotation, the position of the retaining member is fixedly limited since the fastening panel presses against the upper retainer body or the lower retainer body; according to the mentioned structure, it is only necessary to hook the retaining hole on the press member onto the hook foot of the CPU transfer member for assembling the heat sink device and the CPU; then the press portion is used as the supporting point and the wrench portion is depressed downwards; through the resilience of the press member folded upwards, the retaining hole on the retaining member hooks onto another hook foot, thereby the press portion tightly presses against the heat sink device to make it firmly attach the CPU; contrarily, it is only necessary to wrench downwards the press portion to disengage the retaining hole on the retaining member from the hook foot, the press portion is thereby loosened to release the press member to finish the dismounting so as to achieve the objective of being a simple assembly. Since the retaining member is moveable, it adapts to the error of the dimension caused during the manufacturing of the heat sink device or to the different thicknesses and lengths of the heat sink device for adjusting in order to accomplish a fast assembly with the CPU. Furthermore, a lateral rod is disposed on two lateral sides of the said press member adjacent to the press potion; during the assembling, the said lateral rod leans between the heat sink pieces for positioning, thereby to make the retaining member more easy for wrenching and adjusting.

Therefore, the primary objective of the present invention is to provide a retainer structure of a heat sink device (1) with less assembling elements and simplified structure for increasing the production speed and lowering the manufacturing cost.

Another objective of the present invention is to provide a retainer structure of a heat sink device (1) capable of making live adjustment to adapt to the error, thereby to reach the suitable scope of fast assembling and flexible application.

Yet another objective of the present invention is to provide a retainer structure of a heat sink device (1) for easy force exertion and simple assembly, thereby to have the practical value of facilitating the manufacture and easy operation.

Still another objective of the present invention is to provide a retainer structure of a heat sink device (1) requiring no tool for assembling and dismounting, thereby to achieve the convenient objective for both the manufacture and the user.

To enable a further understanding of the specific features and structure of the present invention, the brief description of the drawings below is followed by the detailed description of the preferred embodiment.

### BRIEF DESCRIPTION OF THE DRAWINGS

Figure 1 is an exploded drawing of the members of the present invention.
Figure 2 is a schematic drawing of the assembled present invention.
Figure 3 is a schematic and pictorial drawing of the assembly of the present invention, the heat sink device and the CPU.
Figure 4 is a schematic drawing of the side view of the assembly of the present invention, the heat sink device and the CPU.
Figure 5 is a drawing of the sectional and bottom view of the retaining of the present invention, the heat sink device and the CPU.

### DETAILED DESCRIPTION OF THE PREFERRED EMBODIMENTS

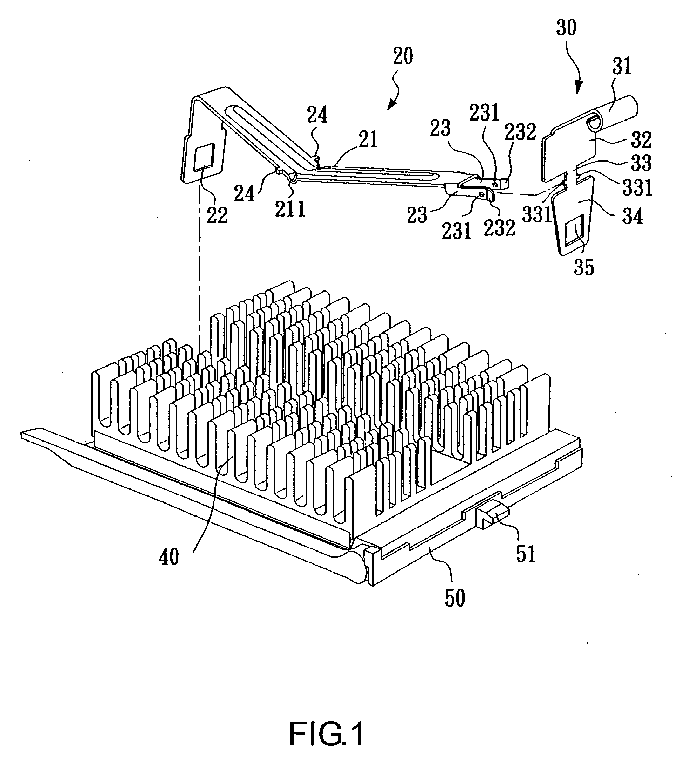

Referring to FIG. 1, an exploded drawing of the members of the present invention of a heat sink retainer structure (1), as shown in the drawing, the present invention comprises a press member (20) and a retaining member (30), wherein the said press member (20) is a long panel body with a press portion (21) formed by bending a proper portion thereof downwards to make the two sides incline and fold upwards with resilience; the said press portion (21) is disposed more closely to one end for increasing the lever of force of the other end to facilitate the press and the force exertion; two lateral sides of the press portion (21) have pressed concave portions (211) to be used for reinforcement during wrenching and not easily subject to break; the end adjacent to the press potion (21) bends downwardly with a retaining hole (22) for retaining a hook foot of a CPU transfer member (50); two sides on the bottom portion at other end thereof extend to have a pair of fastening panels (23); an insert hole (22) is disposed on each fastening panel (23); the tail end of the fastening panel (23) outwardly forms an opening (232) to facilitate a easy insertion and an uneasy release of the retaining member (30); the said retaining member (30) is designed to assemble with the press member (20); the upper end of the retaining member (30) is disposed with a wrench portion (31) with an inclined surface to facilitate an easy force exertion during the assembling; the said wrench portion (31) bends downwardly to form an upper retainer body (32); the lower end of the upper retainer body (32) extends as a support (33) for connecting a lower retainer body (34); on the said lower retainer body (34), an insert hole (35) is disposed to be fixedly hooked to the other hook foot of the transfer member (50) of the CPU; two convex blocks (331) are disposed on the two sides of the support (33); the retaining member (30) inserts easily into the expanded opening (232) at the tail end of the fastening panel (23) to make the two convex blocks (331) just correspondingly insert into the insert holes (231) and further correspondingly conjoin the press member (20) and the retaining member (30); since the convex blocks (331) rotates freely in the insert holes (231), the retaining member (30) can be lively adjusted; during rotation, the position of the retaining member (23) is fixedly limited since it presses against the upper retainer body (32) or the lower retainer body (34).

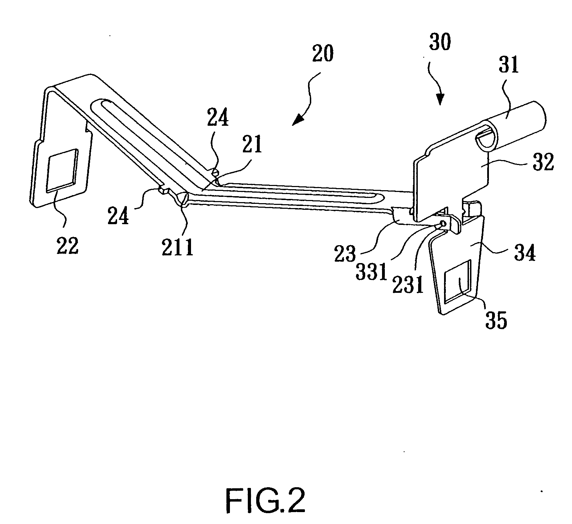

Referring to FIG. 2, a schematic drawing of the assembled present invention, the outwardly expanded opening (232) at the tail end of the fastening panel (23) allows the support (33) inserts easily into to make the two convex blocks (331) correspondingly insert into the insert holes (231) and further conjoin the press member (20) and the retaining member (30); after the retaining member (30) is inserted to connect, since the width of the support (33) connected between the upper retainer body (32) and the lower retainer body (33) is narrower, as the convex blocks (331) insert into the insert holes (231), their positions are fixedly limited from disengagement, wherein, the size of the convex block (30) is smaller than the diameter of the insert hole (231) and it can rotates freely, that makes the retaining member (30) able to be wrenched for adjustment within a certain scope since the fastening panel (23) presses against the upper retainer body (32) and the lower retainer body (34).

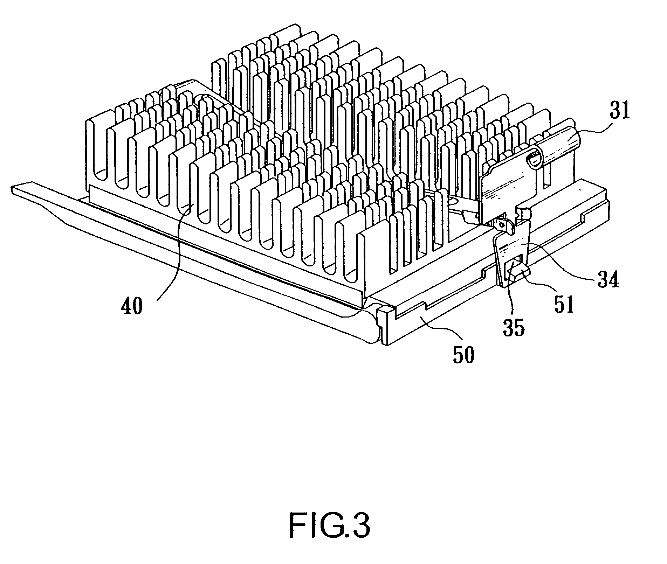

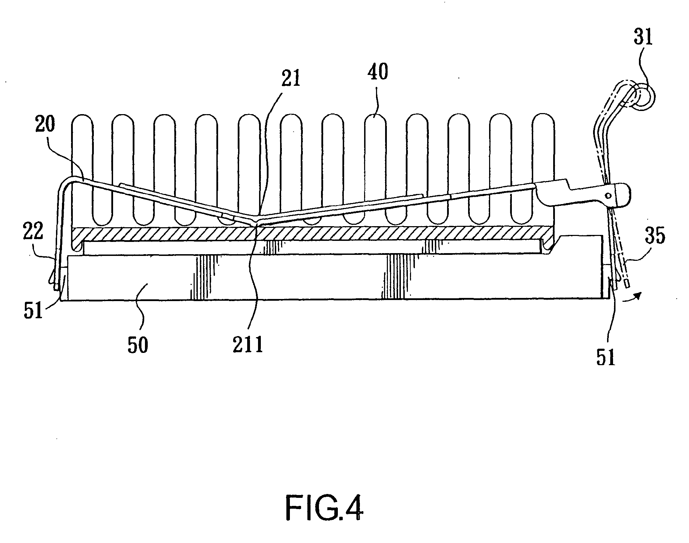

Referring to FIGS 3 and 4, the schematic and cross-sectional drawings of the retaining of the present invention, the heat sink device (40) and the CPU, as shown in the drawing, when assembling the heat sink device (40) and the CPU, after sequentially stacking up the CPU, the CPU transfer member (50) and the heat sink device (40), the retaining hole (22) on the press member (20) is hooked onto the hook foot (51) of the CPU transfer member (50); then the press portion (21) is used as the supporting point and the wrench portion (31) is depressed downwards; through the resilience of the press member (20) folded upwards, the retaining hole (35) on the retaining member (30) hooks onto another hook foot (51), thereby the press portion (51) tightly presses against the heat sink device (40) to make it firmly attach the CPU for a fixed retaining; contrarily, it is only necessary to wrench the press portion (31) downwards to disengage the retaining hole (35) on the retaining member (30) from the hook foot (51), the press portion (21) is thereby loosened to release the press member (20) to finish the dismounting so as to achieve the objective of a simple assembly. Since the retaining member (30) is moveable, it adapts to the error of the dimension caused during the manufacturing of the heat sink device (40) or to the different thicknesses and lengths of the heat sink device (40) for adjusting in order to accomplish a fast assembly with the CPU. The operation is simple, convenient, requires no tool at all and can be easily handled by any person.

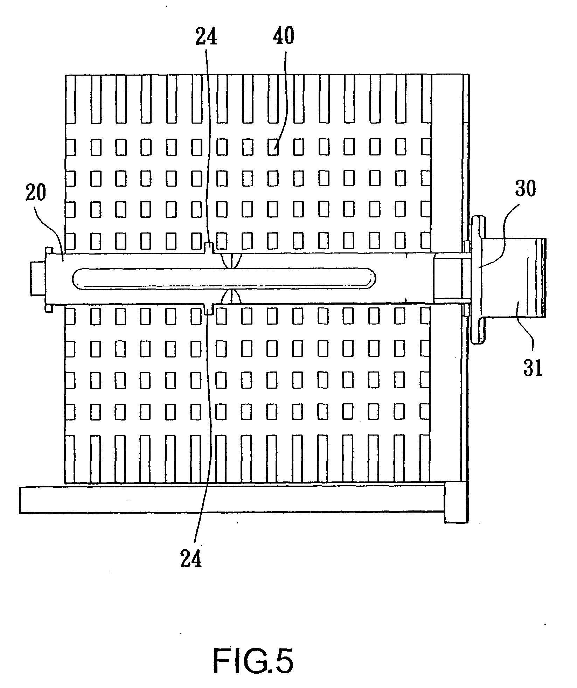

Referring to FIGS. 5, the drawing of the sectional and bottom view of the retaining of the present invention, the heat sink device (40) and the CPU, two lateral rods (24) are disposed on two lateral sides of the said press member (20) adjacent to the press potion (21); during the assembling, the said lateral rods (24) press between the heat sink (40) pieces for positioning, thereby to prevent the retaining member (30) being wrenched from deviating and to make the wrench portion (31) more easy for wrenching and adjusting.

In summation of the foregoing sections, objectives of the invention feature have been achieved completely and the present invention is hereby submitted to the patent bureau for review and the granting of the commensurate patent rights.

It is of course to be understood that the embodiment described herein is merely illustrative of the principles of the invention and that a wide variety of modifications thereto may be effected by persons skilled in the art without departing from the spirit and scope of the invention as set forth in the following claims.

## Claims

1. A heat sink device retainer, more specifically, a retainer structure to be hooked to a hook foot of a CPU transfer member for firmly attaching the heat sink device onto the CPU, comprising a press member and a retaining member, is **characterized that**:
the said press member bends downwardly to form a press portion with resilience; one end thereof bends downwardly to form a retaining hole; two sides of the bottom portion at the other end extend to form a pair of opposite fastening panels; an insert hole is disposed on the said fastening panel and the tail end thereof outwardly forms an opening; a wrench portion is disposed at the upper end of the said retaining member; the wrench portion bends downwardly to form an upper body; the lower end of the upper body extends as a support for connecting a lower retaining body; a retaining hole is disposed on the lower retaining body; two convex blocks are disposed on two sides of the said support and inserted correspondingly into the insert holes for positioning;
through this structure, the retaining member can be lively adjusted to assemble the heat sink device and the computer CPU.

2. A heat sink device retainer (1) according to Claim 1, wherein two lateral sides of the said press member extend as lateral rods for pressing the press member between the heat sink pieces.

3. A heat sink device retainer (1) according to Claim 1, wherein a concave portion is pressed on two sides on the press portion for reinforcement to prevent a break during the assembling,

4. A heat sink device retainer (1) according to Claim 1, wherein the width of the support is smaller then the sizes of the upper and the lower retainer body.
